# EUROPÄISCHE PATENTANMELDUNG

(11) **EP 2 521 432 A2**
(43) Veröffentlichungstag der Anmeldung: **07.11.2012**
(21) Anmeldenummer: 12159006.1
(22) Anmeldetag: 12.03.2012
(51) Int. Cl.: H05K 7/20

(54) **Leistungselektronische Anordnung mit Flüssigkeitskühlung**

(30) Priorität: 05.05.2011 DE 102011100526
(71) Anmelder: SEMIKRON Elektronik GmbH & Co. KG, 90431 Nürnberg (DE)
(72) Erfinder: Beckedahl, Peter, 90522 Oberasbach (DE); Bogen, Ingo, 90425 Nürnberg (DE); Ehler, Ralf, 91459 Markt Erlbach (DE); Dr. Kobolla, Harald, 90556 Seukendorf (DE); Dr. Stockmeier, Thomas, 90471 Nürnberg (DE)

(57) **Zusammenfassung**

Es wird eine leistungselektronische Anordnung (1) beschrieben, umfassend flüssigkeitsgekühlte Leistungshalbleitermodule (11) und eine mit einem Kühlflüssigkeitskreislauf verbindbare Flüssigkeitskühleinrichtung (12), wobei die Leistungshalbleitermodule (11) auf der Flüssigkeitskühleinrichtung (12) angeordnet sind. Die Leistungshalbleitermodule (11) weisen mindestens einen elektrischen Steckverbinder (115) auf, der mit einem von mehreren an der Flüssigkeitskühleinrichtung (12) angeordneten elektrischen Steckverbindern (131 s) verbindbar ist, wobei die mehreren Steckverbinder (131 s) durch einen Bus bildende elektrische Verbindungsleitungen miteinander elektrisch verbunden sind. Die Flüssigkeitskühleinrichtung (12) weist einen Leitungskanal (124) zur Aufnahme der elektrischen Verbindungsleitungen und der mehreren elektrischen Steckverbinder (131 s) auf.

## Beschreibung

Die Erfindung betrifft eine leistungselektronische Anordnung, umfassend flüssigkeitsgekühlte Leistungshalbleitermodule und eine mit einem Kühlflüssigkeitskreislauf verbundene Flüssigkeitskühleinrichtung.

Die Kühlung von Leistungshalbleitermodulen mittels Kühlflüssigkeit hat sich bewährt, weil die Abführung der in den Halbleiterbauelementen entstehenden Verlustwärme mittels Kühlflüssigkeit sehr effektiv ist und die Kühlflüssigkeit mit relativ geringem Aufwand an das zu kühlende Bauelement heranführbar ist.

Aus der DE 60 2005 006 310 T2 ist es bekannt, flüssigkeitsgekühlte Leistungshalbleitermodule übereinander zu stapeln. Beim Wechseln eines Leistungshalbleitermoduls, das innerhalb des Stapels angeordnet ist, muss der Stapel demontiert werden. Weiter sind die Module erst nach dem Stapeln vollständig gekapselt und der Durchflusskanal für die Kühlflüssigkeit ist erst nach dem Stapeln ausgebildet.

Die Aufgabe der vorliegenden Erfindung ist es, eine verbesserte leistungselektronische Anordnung mit Flüssigkeitskühlung anzugeben.

Erfindungsgemäß wird diese Aufgabe mit dem Gegenstand des Anspruchs 1 gelöst. Es wird eine leistungselektronische Anordnung vorgeschlagen, umfassend zwei oder mehr flüssigkeitsgekühlte Leistungshalbleitermodule und eine mit einem Kühlflüssigkeitskreislauf verbindbare Flüssigkeitskühleinrichtung, wobei die Leistungshalbleitermodule auf der Flüssigkeitskühleinrichtung angeordnet sind, wobei vorgesehen ist, dass die Leistungshalbleitermodule jeweils mindestens einen elektrischen Steckverbinder aufweisen, der mit einem von mehreren an der Flüssigkeitskühleinrichtung angeordneten elektrischen Steckverbindern verbindbar ist, wobei die mehreren Steckverbinder durch einen Bus bildende elektrische Verbindungsleitungen elektrisch miteinander verbunden sind, und dass die Flüssigkeitskühleinrichtung einen Leitungskanal zur Aufnahme der elektrischen Verbindungsleitungen und der mehreren elektrischen Steckverbinder aufweist.

Die leistungselektronische Anordnung zeichnet sich dadurch aus, dass die Flüssigkeitskühleinrichtung mehrere elektrische Steckverbinder aufweist, die durch einen Bus bildende elektrische Verbindungsleitungen elektrisch miteinander verbunden sind, so dass die Montage und ggf. Demontage der Module auf der Flüssigkeitskühleinrichtung sehr rasch und fehlerfrei möglich ist.

Der Kühlflüssigkeitskreislauf umfasst neben der Flüssigkeitskühleinrichtung, auf der die Leistungshalbleitermodule angeordnet sind, eine Kühlmittelpumpe und einen Wärmetauscher, in dem die in den Leistungshalbleitermodulen erwärmte Kühlflüssigkeit gekühlt wird.

Es kann vorgesehen sein, dass die Flüssigkeitskühleinrichtung zwei Durchtrittskanäle für eine Kühlflüssigkeit aufweist, die mit Kühlflüssigkeits-Auslässen bzw. mit Kühlflüssigkeits-Einlässen verbunden sind, die an der Oberseite der Flüssigkeitskühleinrichtung angeordnet sind, dass die Leistungshalbleitermodule einen modulseitigen Kühlflüssigkeitseinlass und einen modulseitigen Kühlflüssigkeitsauslass aufweisen, und dass die Leistungshalbleitermodule durch Aufsetzen auf die Flüssigkeitskühleinrichtung mit den Durchtrittskanälen flüssigkeitsdicht verbindbar sind. Es sind also sowohl an der Flüssigkeitskühleinrichtung als auch an den Leistungshalbleitermodulen Verbindungselemente zur Durchleitung der Kühlflüssigkeit vorgesehen, wobei vorteilhafterweise zwischen zwei korrespondierenden Verbindungselementen ein Dichtungselement vorgesehen sein kann. Das Dichtungselement kann beispielsweise als ein O-Ring oder ein flaches Dichtungselement aus Gummi oder dergleichen, als Klebepad oder als Kleberschicht, beispielsweise aus Silikonkautschuk, ausgebildet sein.

Der Leitungskanal kann die Flüssigkeitskühleinrichtung parallel zu ihrer Längsachse durchgreifen.

Es kann vorgesehen sein, dass der Leitungskanal zwischen den beiden Durchtrittskanälen angeordnet ist.

Weiter kann vorgesehen sein, dass die mehreren elektrischen Steckverbinder der Flüssigkeitskühleinrichtung auf einer Busleiterplatte angeordnet sind, und dass die elektrischen Verbindungsleitungen als Leitungsbahnen der Busleiterplatte ausgebildet sind. Es kann sich vorzugsweise um eine streifenförmige Leiterplatte handeln.

Die mehreren elektrischen Steckverbinder können in der Oberseite der Flüssigkeitskühleinrichtung angeordnete Durchgangslöcher zumindest teilweise durchgreifen.

Der Leitungskanal kann einen rechteckförmigen Querschnitt aufweisen, der so bemessen sein kann, dass die Busleiterplatte in den Leitungskanal axial einschiebbar ist.

Die lichte Weite des Leitungskanals kann der Breite der Busleiterplatte und die lichte Höhe des Leitungskanals kann der Höhe der Busleiterplatte zuzüglich der Höhe der auf der Busleiterplatte angeordneten elektrischen Steckverbinder entsprechen.

Zwischen der Unterseite der Busleiterplatte und der Unterseite des Leitungskanals kann ein vorzugsweise aus elektrisch isolierendem Material ausgebildetes Abstandselement angeordnet sein, das die Busleiterplatte soweit anhebt, dass die elektrischen Steckverbinder zumindest teilweise die Durchgangslöcher in der Oberseite der Flüssigkeitskühleinrichtung durchgreifen.

Die Innenkontur der Durchgangslöcher kann kongruent zu der Außenkontur des mindestens einen Steckverbinders der Leistungshalbleitermodule und des mindestens einen Steckverbinders des weiter unten beschriebenen Steuerungsmoduls ausgebildet sein. Die Innenkontur der Durchgangslöcher wirkt so als Führung beim Aufsetzen der vorgenannten Module auf die Flüssigkeitskühleinrichtung.

Es kann vorgesehen sein, dass der mindestens eine elektrische Steckverbinder des Leistungshalbleitermoduls als elektrische Buchse und der korrespondierende elektrische Steckverbinder der mehreren elektrischen Steckverbinder der Flüssigkeitskühleinrichtung als elektrischer Einbaustecker ausgebildet ist oder umgekehrt.

Weiter kann vorgesehen sein, dass der mindestens eine elektrische Steckverbinder des Leistungshalbleitermoduls mit dem korrespondierenden Steckverbinder der mehreren elektrischen Steckverbinder der Flüssigkeitskühleinrichtung durch Aufsetzen des Leistungshalbleitermoduls auf die Flüssigkeitskühleinrichtung elektrisch verbindbar ist.

In einer vorteilhaften Ausbildung kann vorgesehen sein, dass die leistungselektronische Anordnung weiter ein Steuerungsmodul umfasst, das auf der Flüssigkeitskühleinrichtung angeordnet ist, und dass das Steuerungsmodul mindestens einen elektrischen Steckverbinder aufweist, der mit einem von den mehreren an der Flüssigkeitskühleinrichtung angeordneten elektrischen Steckverbindern verbindbar ist. Das Steuerungsmodul kann weitere elektrische Anschlüsse aufweisen, um es beispielsweise mit einer übergeordneten Steuerungs- und/oder Kontrolleinheit und/oder mit einer Eingabeeinheit für Steuerungsbefehle zu verbinden.

Der mindestens eine elektrische Steckverbinder des Steuerungsmoduls kann als elektrische Buchse und der korrespondierende Steckverbinder der mehreren elektrischen Steckverbinder der Flüssigkeitskühleinrichtung kann als elektrischer Einbaustecker ausgebildet sein oder umgekehrt.

Es kann vorgesehen sein, dass der mindestens eine elektrische Steckverbinder des Steuerungsmoduls mit dem korrespondierenden elektrischen Steckverbinder der Flüssigkeitskühleinrichtung durch Aufsetzen des Steuerungsmoduls auf die Flüssigkeitskühleinrichtung elektrisch verbindbar ist.

Die Leistungshalbleitermodule und/oder das Steuerungsmodul können verpolsicher ausgebildet sein. Dazu können die Module und/oder die Flüssigkeitskühleinrichtung mechanische Vorrichtungen aufweisen, die verhindern, dass falsche Zuordnungen der Stromwege hergestellt werden. Es können auch Einbaustecker vorgesehen sein, die nur in einer Lage zur Buchse eingesteckt werden können. Beispielsweise können Nasen vorgesehen sein oder die Anordnung der Steckerstifte so gewählt sein, dass nur eine Steckvariante zugelassen ist.

Bei einer besonders vorteilhaften dreidimensionalen Ausgestaltung der Leistungshalbleitermodule mit im Wesentlichen quaderförmigem Aufbau sind an der Bodenseite des Leistungshalbleitermoduls die elektrischen Steckverbinder für die Steuerung des Leistungshalbleitermoduls sowie der modulseitige Kühlflüssigkeitseinlass und der modulseitige Kühlflüssigkeitsauslass angeordnet und an den beiden Stirnseiten einander gegenüberliegend Gleichspannungsanschlüsse und Wechselspannungsanschlüsse zur Einbindung des Leistungshalbleitermoduls in einen Leistungsstromkreis. Auf der Flüssigkeitskühleinrichtung sind die Leistungshalbleitermodule mit einander zugewandten Seitenflächen dicht an dicht angeordnet. Dadurch sind auch bei der so gebildeten leistungselektronischen Anordnung die Gleichspannungsanschlüsse auf der einen Seite und die Wechselspannungsanschlüsse auf der anderen Seite angeordnet, wodurch beispielsweise eine Kaskadierung der Leistungshalbleitermodule besonders einfach möglich ist.

Die Erfindung wird nun anhand von Ausführungsbeispielen näher erläutert. Es zeigen
- Fig. 1: ein Ausführungsbeispiel einer erfindungsgemäßen leistungselektronischen Anordnung in einer perspektivischen Schnittdarstellung;
- Fig. 2: die Flüssigkeitskühleinrichtung in Fig. 1 in einer perspektivischen Teilschnittdarstellung;
- Fig. 3: ein teilweise aufgebautes Leistungshalbleitermodul in Fig. 1 in perspektivischer Darstellung;
- Fig. 4: das Leistungshalbleitermodul in Fig. 3 mit aufgesetzter Steuerungsleiterplatte;
- Fig. 5 und 6: ein zweites Ausführungsbeispiel eines Leistungshalbleitermoduls der leistungselektronischen Anordnung in Fig. 1 in perspektivischer Darstellung ohne Gehäuse;
- Fig. 7: das Leistungshalbleitermodul in Fig. 5 und 6 mit Gehäuse in perspektivischer Darstellung;
- Fig. 8a: das Leistungshalbleitermodul in Fig. 7 mit Blick auf die Gleichspannungsanschlüsse;
- Fig. 8b: das Leistungshalbleitermodul in Fig. 7 mit Blick auf die Wechselspannungsanschlüsse.

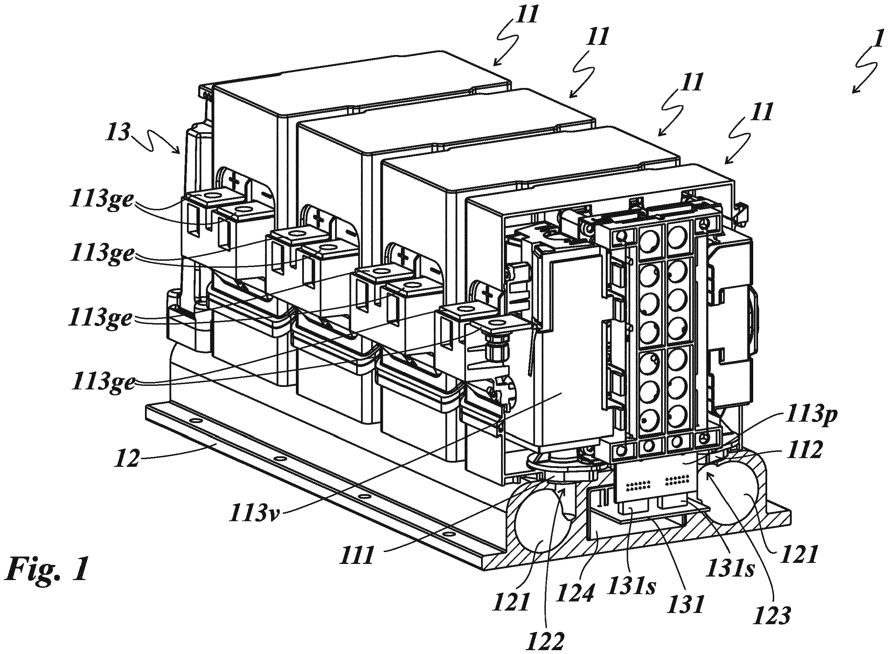

Fig. 1 zeigt eine leistungselektronische Anordnung 1, die beispielsweise als Stromrichter-Einheit für Windkraftanlagen einsetzbar ist. Die leistungselektronische Anordnung 1 ist modular aufgebaut und umfasst in dem in Fig. 1 dargestellten Ausführungsbeispiel sechs in Halbbrückenschaltung ausgebildete flüssigkeitsgekühlte Leistungshalbleitermodule 11, wobei wegen der Schnittdarstellung in Fig. 1 nur vier Leistungshalbleitermodule dargestellt sind. Die Leistungshalbleitermodule 11 sind nebeneinander auf einer Montagefläche einer Flüssigkeitskühleinrichtung 12 angeordnet.

Die Flüssigkeitskühleinrichtung 12 ist im Wesentlichen als ein plattenförmiger Montagekörper ausgebildet und von zwei parallel angeordneten Durchtrittskanälen 121 für die Kühlflüssigkeit durchgriffen. Die Flüssigkeitskühleinrichtung 12 ist in einen nicht dargestellten Kühlflüssigkeitskreislauf eingebunden und dient der Verteilung einer Kühlflüssigkeit auf die Leistungshalbleitermodule. Die Kühlflüssigkeit wird beispielsweise mit einer Kühlmittelpumpe gefördert und in einem Wärmetauscher gekühlt. In den einen der beiden Durchtrittskanäle 121 strömt kalte Kühlflüssigkeit ein und aus dem anderen der beiden Durchtrittskanäle 121 strömt in den Leistungshalbleitermodulen 11 erwärmte Kühlflüssigkeit aus. An den Endabschnitten der Durchtrittskanäle 121 ist jeweils ein Anschlussstück 121 a bzw. ein Verschlussstück 121v angeordnet. In dem in Fig. 1 dargestellten Ausführungsbeispiel sind die Verschlussstücke 121v und die Anschlusstücke 121 a jeweils an einer Stirnseite der Flüssigkeitskühleinrichtung 12 angeordnet. Es kann aber auch vorgesehen sein, die Verschlussstücke 121v und die Anschlusstücke 121 a wechselseitig anzuordnen, so dass die Kühlflüssigkeit an der einen Stirnseite der Flüssigkeitskühleinrichtung 12 eintritt und an der anderen Stirnseite austritt.

Die Durchtrittskanäle 121 sind mit Kühlflüssigkeits-Auslässen 122 bzw. mit Kühlflüssigkeits-Einlässen 123 verbunden, die an der Oberseite der Flüssigkeitskühleinrichtung 12 angeordnet sind.

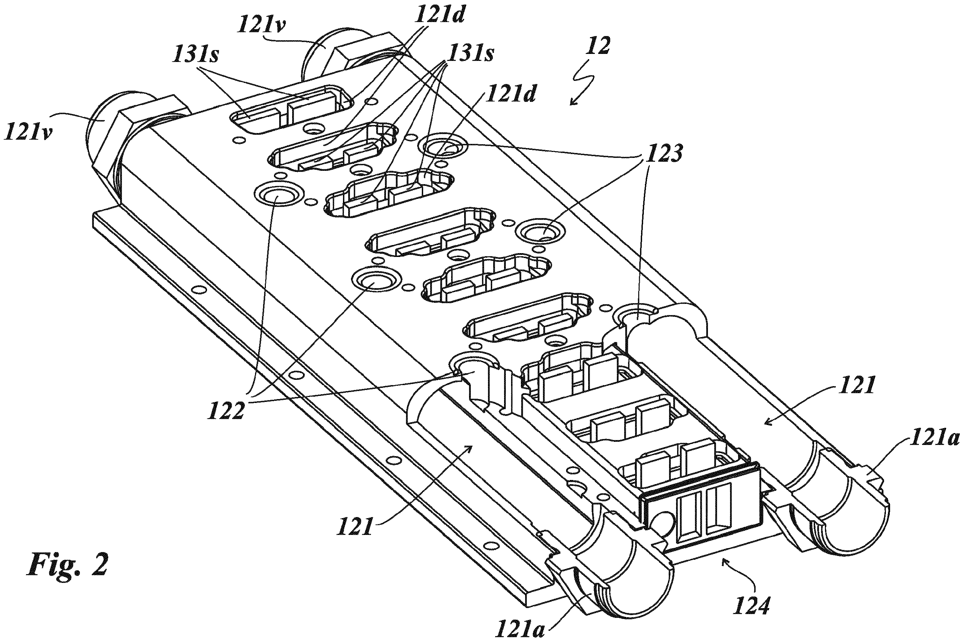

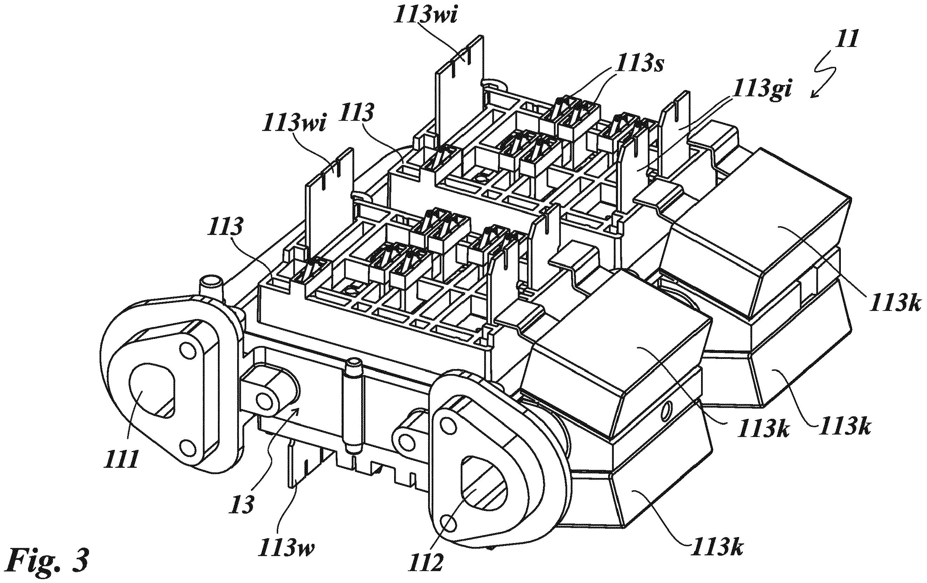

Die Leistungshalbleitermodule 11 weisen an ihrer Unterseite einen modulseitigen Kühlflüssigkeitseinlass 111 und einen modulseitigen Kühlflüssigkeitsauslass 112 auf. Der Kühlflüssigkeitseinlass 111 ist im montierten Zustand mit einem der Kühlflüssigkeits-Auslässe 122 der Flüssigkeitskühleinrichtung 12 flüssigkeitsdicht verbunden. Der Kühlflüssigkeitsauslass 112 ist im montierten Zustand mit einem der Kühlflüssigkeits-Einlässe 123 der Flüssigkeitskühleinrichtung 12 flüssigkeitsdicht verbunden. Wie in Fig. 3 zu erkennen, sind der modulseitige Kühlflüssigkeitseinlass 111 und der modulseitige Kühlflüssigkeitsauslass 112 stutzenförmig ausgebildet und stehen aus der Unterseite des Leistungshalbleitermoduls 11 hervor. Die Stirnseiten des Kühlflüssigkeitseinlasses 123 und des Kühlflüssigkeitsauslasses 122 der Flüssigkeitskühleinrichtung 12 weisen eine Ausnehmung für ein Dichtungselement auf (siehe Fig. 2). Es handelt sich beispielsweise um ein ringförmiges Dichtungselement mit kreisförmigem Querschnitt, das aus einem gummielastischen Material ausgebildet ist, beispielsweise aus Silikongummi. Im montierten Zustand bildet das Dichtungselement eine Flüssigkeitsdichtung zwischen dem Leistungshalbleitermodul 11 und der Flüssigkeitskühleinrichtung 12. Die korrespondierenden Kühlflüssigkeits-Einlässe und -Auslässe bilden zusammen mit den Dichtungselementen lösbare Kühlmittelverbindungseinrichtungen. Es kann aber auch vorgesehen sein, die Dichtungselemente als Kleberschichten auszubilden, woraus unlösbare oder bedingt lösbare Kühlmittelverbindungseinrichtungen resultieren.

Der modulseitige Kühlflüssigkeitseinlass 111 sowie der modulseitige Kühlflüssigkeitsauslass 112 können jeweils Gewindelöcher aufweisen, in die Befestigungsschrauben eingreifen. Die Befestigungsschrauben durchgreifen Durchgangslöcher in der Flüssigkeitskühleinrichtung 12 und verbinden so das Leistungshalbleitermodul 11 mit der Flüssigkeitskühleinrichtung 12, wobei beim Anziehen der Befestigungsschrauben das Dichtungselement verpresst wird.

Fig. 3 zeigt ein teilweise aufgebautes Leistungshalbleitermodul 11 ohne Gehäuse, das in dem dargestellten Beispiel vier leistungselektronische Subsysteme 113 aufweist, die auf einer gemeinsamen Kühleinrichtung 114 angeordnet sind. Die vier Subsysteme 113 sind zu je zwei Subsystemen einander gegenüberstehend beidseitig der Kühleinrichtung 114 angeordnet. Bei den leistungselektronischen Subsystemen 113 kann es sich um die o. g. Halbbrückenschaltungen handeln.

Die Kühleinrichtung 114 kann aus einem Kunststoff oder aus Metall gebildet sein. Die Kühleinrichtung 114 weist einen als Verteilungskanal ausgebildeten Eingangsabschnitt und einen als Sammlerkanal ausgebildeten Ausgangsabschnitt für die Kühlflüssigkeit auf. Der Eingangsabschnitt und der Ausgangsabschnitt sind parallel zueinander angeordnet. Zwischen den beiden Abschnitten sind vier trogförmige Kühlkammern angeordnet, deren Trogöffnung jeweils von dem Substrat der zu kühlenden leistungselektronischen Subsysteme 113 überdeckt ist. Zwischen der die Trogöffnung umgebenden Stirnfläche und der der Kühlkammer zugewandten Substratoberfläche des leistungselektronischen Subsystems 113 ist ein ringförmiges Dichtelement angeordnet (in Fig. 3 nicht dargestellt), das beispielsweise in einer umlaufenden Nut in der Stirnfläche der zugeordneten Kühlkammer angeordnet sein kann.

Die Kühlflüssigkeit tritt in den modulseitigen Kühlflüssigkeitseinlass 111 am Eingang des Eingangsabschnitts in die Kühleinrichtung ein und fließt von dort in vier Kühlkammern, in denen sie in direkten Kontakt mit dem Substrat der Halbleiterbauelemente der leistungselektronischen Subsysteme 113 gelangt. Bei dieser bevorzugten Ausbildung ist vorausgesetzt, dass die Kühlflüssigkeit elektrisch nicht leitend ist. Die aus den Kühlkammern austretende erwärmte Kühlflüssigkeit wird im Ausgangsabschnitt der Kühleinrichtung 114 gesammelt und tritt an dem modulseitigen Kühlflüssigkeitsauslass 112 aus.

Die leistungselektronischen Subsysteme 113 weisen einen internen Wechselspannungsanschluss 113wi, zwei interne Gleichspannungsanschlüsse 113gi (siehe Fig. 3) und zwei externe Gleichspannungsanschlüsse 113ge auf (siehe Fig. 1). Die internen Gleichspannungsanschlüsse 113gi sind untereinander mittels einer internen Gleichspannungsverschienung 113v (siehe Fig. 1) sowie mit Kondensatoren 113k und mit den externen Gleichspannungsanschlüssen 113ge verbunden.

Die Kondensatoren 113k sind paarweise auf Kühlblöcken montiert, die mit der Kühleinrichtung 114 in thermischem Kontakt stehen oder Teil der Kühleinrichtung 114 sind. Es kann auch vorgesehen sein, das Leistungshalbleitermodul 11 ohne Kondensatoren auszubilden, wobei die bedarfsweise Nachrüstung mit Kondensatoren vorgesehen sein kann.

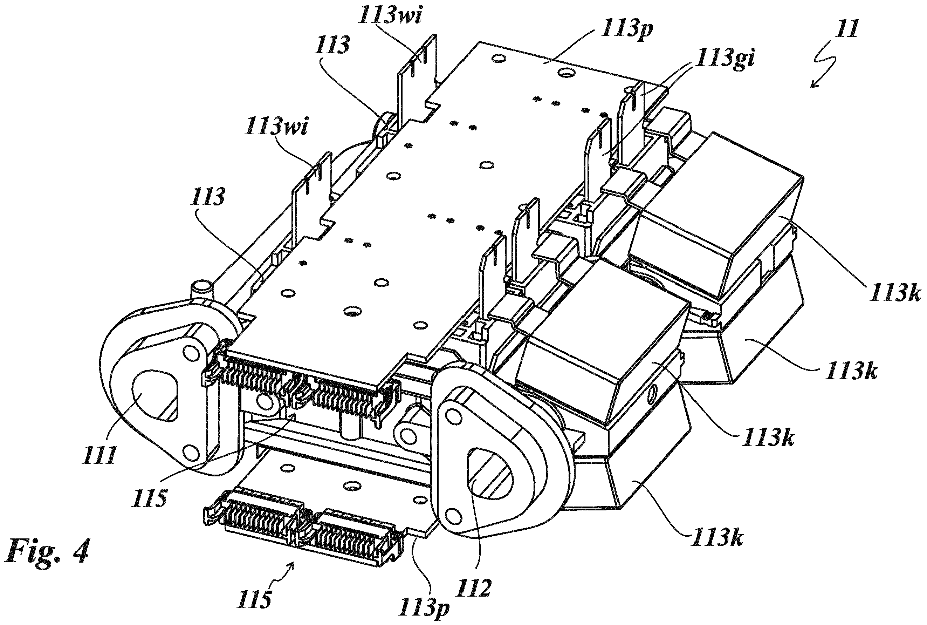

Die leistungselektronischen Subsysteme 113 weisen Steuerungsanschlüsse 113s auf, die als Kontaktfedern ausgebildet sind und an Kontakten einer über den Steuerungsanschlüssen 113s angeordneten Steuerungsleiterplatte 113p (siehe Fig. 4) unter Druck anliegen. Die Steuerungsleierplatte 113p weist elektrische Leiterbahnen auf, die die Steuerungsanschlüsse 113s mit Kontaktfedern von elektrischen Steckverbindern 115 verbinden, die an einer dem Kühlflüssigkeitseinlass 111 bzw. dem Kühlflüssigkeitsauslass 112 zugewandten Stirnseite der Steuerungsleiterplatte 113p angeordnet sind. Entsprechend der Anzahl der Subsysteme 113 sind in dem Gehäuse zwei Steuerungsleiterplatten 113p einander gegenüberliegend angeordnet, wie in Fig. 4 zu erkennen. Jede der beiden Steuerungsleiterplatten 113p ist mit Steuerungsanschlüssen 113s von zwei Subsystemen 113 verbunden.

Auf der Flüssigkeitskühleinrichtung 12 ist weiter ein Steuerungsmodul 13 angeordnet, das die Leistungshalbleitermodule 11 steuert. Das Steuerungsmodul 13 weist an seiner unteren Stirnfläche elektrische Steckverbinder auf (in Fig. 1 nicht dargestellt). Zur elektrischen Verbindung des Steuerungsmoduls 13 mit den Leistungshalbleitermodulen 11 ist eine streifenförmige Bus-Leiterplatte 131 vorgesehen, die in einem die Flüssigkeitskühleinrichtung 12 durchgreifenden Leitungskanal 124 angeordnet ist. Auf der Bus-Leiterplatte 131 sind elektrische Steckverbinder 131 s angeordnet, deren Kontakte durch Leiterbahnen miteinander verbunden sind, wobei entsprechend dem gewählten Bus-System die Steckverbinder 131 s parallel verbunden sind. Die Steckverbinder 131 s bilden zusammen mit den weiter oben beschriebenen elektrischen Steckverbindern 115 des Leistungshalbleitermoduls lösbare elektrische Steckverbindungen, so dass die Steuerungsanschlüsse 124 der Leistungshalbleitermodule 1 auf das Bus-System geschaltet sind. Es kann vorgesehen sein, dass der Steckverbinder 131 s als Buchse und der Steckverbinder 115 als Einbaustecker ausgebildet ist oder umgekehrt.

Der Leitungskanal 124 durchgreift die Flüssigkeitskühleinrichtung 12 parallel zu ihrer Längsachse und ist zwischen den beiden Durchtrittskanälen 121 angeordnet. In dem in Fig. 1 und 2 dargestellten Ausführungsbeispiel weist der Leitungskanal 124 einen rechteckförmigen Querschnitt auf, der so bemessen ist, dass die Busleiterplatte 131 in den Leitungskanal 124 axial einschiebbar ist. Die lichte Weite des Leitungskanals 124 entspricht der Breite der Busleiterplatte 131 und die lichte Höhe des Leitungskanals 124 entspricht der Höhe der Busleiterplatte 131 zuzüglich der Höhe der auf der Busleiterplatte 131 angeordneten elektrischen Steckverbinder 131 s. Nach dem Einschieben der Busleiterplatte 131 in den Leitungskanal 124 wird die Busleiterplatte 131 soweit angehoben, dass die elektrischen Steckverbinder 131 s zumindest teilweise Durchgangslöcher 121 d in der Oberseite der Flüssigkeitskühleinrichtung 12 durchgreifen (siehe Fig. 2). Der Abstandsraum zwischen der Unterseite der Busleiterplatte 131 und der Unterseite des Leitungskanals 124 kann durch ein Abstandselement ausgefüllt sein, vorzugsweise durch ein aus elektrisch isolierendem Material gebildetes Abstandselement. Die Innenkontur der Durchgangslöcher 121d ist kongruent zu der Außenkontur der Steckverbinder 115 der Leistungshalbleitermodule 11 und des Steuerungsmoduls 13. Die Innenkontur der Durchgangslöcher 121 d wirkt so als Führung beim Aufsetzen der vorgenannten Module auf die Flüssigkeitskühleinrichtung 12.

Es kann auch vorgesehen sein, den Leitungskanal 124 als offenen Leitungskanal auszubilden, der von einer Abdeckplatte überdeckbar ist , die zugleich als Abstandselement ausgebildet sein kann, und die Busleiterplatte 131 von der Unterseite der Flüssigkeitskühleinrichtung 12 einzuführen.

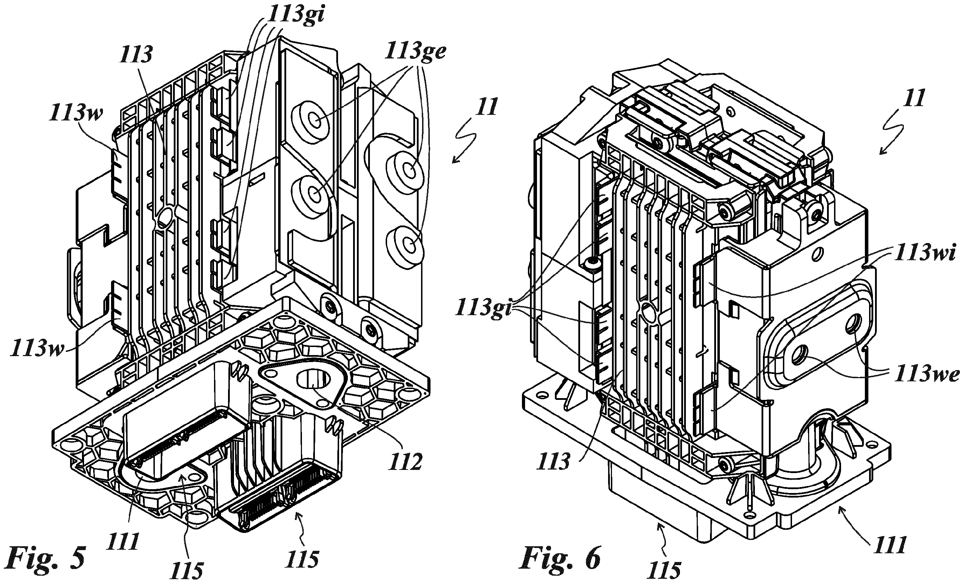

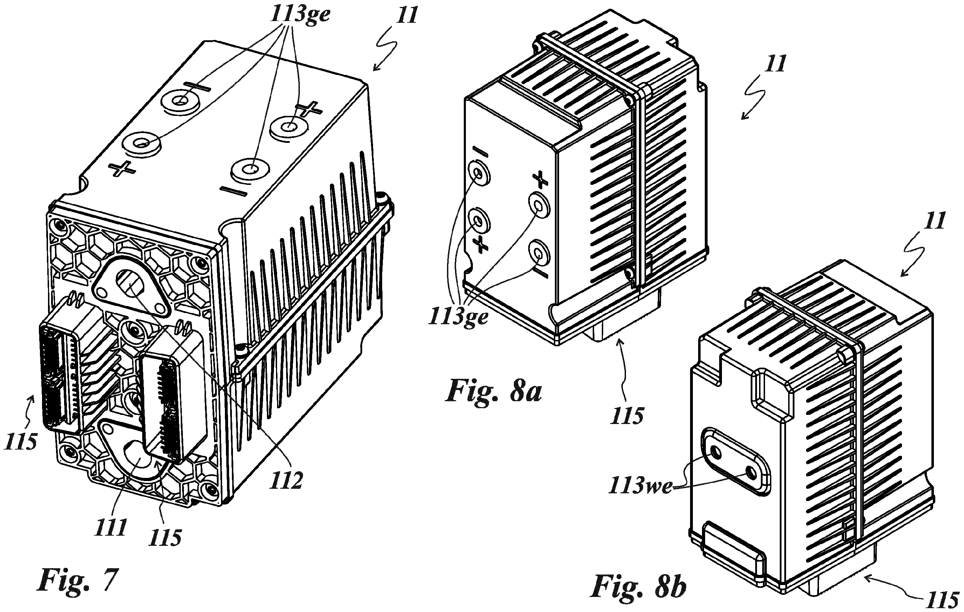

Die Fig. 5 und 6 zeigen ein Ausführungsbeispiel eines Leistungshalbleitermoduls 11 ohne Kondensatoren, wobei nur der innere Aufbau dargestellt ist. Fig. 5 zeigt eine perspektivische Ansicht mit Blick auf die externen Gleichspannungsanschlüsse 113ge. Fig. 6 zeigt eine perspektivische Ansicht mit Blick auf externe Wechselspannungsanschlüsse 113we. Die Fig. 7 und 8a sowie 8b zeigen das in Fig. 5 und 6 dargestellte Leistungshalbleitermodul 11 mit Gehäuse.

Wie in Fig. 5 zu erkennen, sind vier externe Gleichspannungsanschlüsse 113ge vorgesehen, wobei vorzugsweise die Plus- und Minus-Anschlüsse doppelt ausgebildet und in zwei übereinander liegenden Reihen so angeordnet sind, dass bei zwei benachbarten Leistungshalbleitermodulen 11 die externen Gleichspannungsanschlüsse 113ge auf kürzestem Weg zur Ausbildung einer Reihenschaltung miteinander verbunden werden können (siehe Fig. 7 und 8a). Aus den Figuren 5 bis 8 wird der Vorteil der gewählten dreidimensionalen Ausgestaltung deutlich: An der Bodenseite des Leistungshalbleitermoduls 11 sind die elektrischen Steckverbinder 115 für die Steuerung des Leistungshalbleitermoduls 11 sowie der modulseitige Kühlflüssigkeitseinlass 111 und der modulseitige Kühlflüssigkeitsauslass 112 angeordnet und an den beiden Stirnseiten einander gegenüberliegend die externen Gleichspannungsanschlüsse 113ge sowie die externen Wechselspannungsanschlüsse 113we. Auf der Flüssigkeitskühleinrichtung 12 sind die Leistungshalbleitermodule 11 mit einander zugewandten Seitenflächen dicht an dicht angeordnet.

Bei dem in Fig. 5 bis 8 dargestellten Ausführungsbeispiel sind sowohl die externen Gleichspannungsanschlüsse 113ge als auch die externen Wechselspannungsanschlüsse 113we als Gewindesacklöcher ausgebildet, in die Befestigungsschrauben zur Herstellung von elektrischen Schraubverbindungen eindrehbar sind.

### Bezugszeichenliste

- 1: leistungselektronische Anordnung
- 11: Leistungshalbleitermodul
- 12: Flüssigkeitskühleinrichtung
- 13: Steuerungsmodul
- 111: modulseitiger Kühlflüssigkeitseinlass
- 112: modulseitiger Kühlflüssigkeitsauslass
- 113: leistungselektronisches Subsystem
- 113ge: externer Gleichspannungsanschluss
- 113gi: interner Gleichspannungsanschluss
- 113k: Kondensator
- 113p: Steuerungsleiterplatte
- 113s: Steuerungsanschluss
- 113v: Gleichspannungsverschienung
- 113we: externer Wechselspannungsanschluss
- 113wi: interner Wechselspannungsanschluss
- 114: Kühleinrichtung
- 115: elektrischer Steckverbinder
- 121: Durchtrittskanal
- 121a: Anschlussstück
- 121d: Durchgangsloch
- 121v: Verschlussstück
- 122: Kühlflüssigkeitsauslass
- 123: Kühlflüssigkeitseinlass
- 124: Leitungskanal
- 131: Busleiterplatte
- 131s: elektrischer Steckverbinder

## Patentansprüche

1. Leistungselektronische Anordnung (1), umfassend zwei oder mehr flüssigkeitsgekühlte Leistungshalbleitermodule (11) und eine mit einem Kühlflüssigkeitskreislauf verbindbare Flüssigkeitskühleinrichtung (12), wobei die Leistungshalbleitermodule (11) auf der Flüssigkeitskühleinrichtung (12) angeordnet sind,
**dadurch gekennzeichnet,**
**dass** die Leistungshalbleitermodule (11) jeweils mindestens einen elektrischen Steckverbinder (115) aufweisen, der mit einem von mehreren an der Flüssigkeitskühleinrichtung (12) angeordneten elektrischen Steckverbindern (131 s) verbindbar ist, wobei die mehreren Steckverbinder (131 s) durch einen Bus bildende elektrische Verbindungsleitungen elektrisch miteinander verbunden sind, und dass die Flüssigkeitskühleinrichtung (12) einen Leitungskanal (124) zur Aufnahme der elektrischen Verbindungsleitungen und der mehreren elektrischen Steckverbinder (131 s) aufweist.

2. Leistungselektronische Anordnung nach Anspruch 1,
**dadurch gekennzeichnet,**
**dass** die Flüssigkeitskühleinrichtung (12) zwei Durchtrittskanäle (121) für eine Kühlflüssigkeit aufweist, die mit Kühlflüssigkeits-Auslässen (122) bzw. mit Kühlflüssigkeits-Einlässen (123) verbunden sind, die an der Oberseite der Flüssigkeitskühleinrichtung (12) angeordnet sind, dass die Leistungshalbleitermodule (11) einen modulseitigen Kühlflüssigkeitseinlass (111) und einen modulseitigen Kühlflüssigkeitsauslass (112) aufweisen, und
**dass** die Leistungshalbleitermodule (11) durch Aufsetzen auf die Flüssigkeitskühleinrichtung (12) mit den Durchtrittskanälen (121) flüssigkeitsdicht verbindbar sind.

3. Leistungselektronische Anordnung nach Anspruch 1 oder 2,
**dadurch gekennzeichnet,**
**dass** der Leitungskanal (124) die Flüssigkeitskühleinrichtung (12) parallel zu ihrer Längsachse durchgreift.

4. Leistungselektronische Anordnung nach einem der vorangehenden Ansprüche,
**dadurch gekennzeichnet,**
**dass** der Leitungskanal (124) zwischen den beiden Durchtrittskanälen (121) angeordnet ist.

5. Leistungselektronische Anordnung nach einem der vorangehenden Ansprüche,
**dadurch gekennzeichnet,**
**dass** die mehreren elektrischen Steckverbinder (131 s) der Flüssigkeitskühleinrichtung (12) auf einer Busleiterplatte (131) angeordnet sind, und
**dass** die elektrischen Verbindungsleitungen als Leitungsbahnen der Busleiterplatte (131) ausgebildet sind.

6. Leistungselektronische Anordnung nach einem der vorangehenden Ansprüche,
**dadurch gekennzeichnet,**
**dass** die mehreren elektrischen Steckverbinder (131 s) in der Oberseite der Flüssigkeitskühleinrichtung (12) angeordnete Durchgangslöcher (121 d) zumindest teilweise durchgreifen.

7. Leistungselektronische Anordnung nach einem der vorangehenden Ansprüche,
**dadurch gekennzeichnet,**
**dass** der mindestens eine elektrische Steckverbinder (115) des Leistungshalbleitermoduls (11) als elektrische Buchse und der korrespondierende Steckverbinder der mehreren elektrischen Steckverbinder (131 s) der Flüssigkeitskühleinrichtung (12) als elektrischer Einbaustecker ausgebildet ist oder umgekehrt.

8. Leistungselektronische Anordnung nach einem der vorangehenden Ansprüche,
**dadurch gekennzeichnet,**
**dass** der mindestens eine elektrische Steckverbinder (115) des Leistungshalbleitermoduls (11) mit dem korrespondierenden Steckverbinder der mehreren elektrischen Steckverbinder (131 s) der Flüssigkeitskühleinrichtung (12) durch Aufsetzen des Leistungshalbleitermoduls (11) auf die Flüssigkeitskühleinrichtung (12) elektrisch verbindbar ist.

9. Leistungselektronische Anordnung nach einem der vorangehenden Ansprüche,
**dadurch gekennzeichnet,**
**dass** die leistungselektronische Anordnung (1) weiter ein Steuerungsmodul (13) umfasst, das auf der Flüssigkeitskühleinrichtung (12) angeordnet ist, und
**dass** das Steuerungsmodul (13) mindestens einen elektrischen Steckverbinder (115) aufweist, der mit einem von den mehreren an der Flüssigkeitskühleinrichtung (12) angeordneten elektrischen Steckverbindern (131 s) verbindbar ist.

10. Leistungselektronische Anordnung nach Anspruch 9,
**dadurch gekennzeichnet,**
**dass** der mindestens eine elektrische Steckverbinder (115) des Steuerungsmoduls (13) als elektrische Buchse und der korrespondierende Steckverbinder der mehreren elektrischen Steckverbinder der Flüssigkeitskühleinrichtung (12) als elektrischer Einbaustecker ausgebildet ist oder umgekehrt.

11. Leistungselektronische Anordnung nach Anspruch 9 oder 10,
**dadurch gekennzeichnet,**
**dass** der mindestens eine elektrische Steckverbinder (115) des Steuerungsmoduls (13) mit dem korrespondierenden Steckverbinder der mehreren elektrischen Steckverbinder (131 s) der Flüssigkeitskühleinrichtung (12) durch Aufsetzen des Steuerungsmoduls (13) auf die Flüssigkeitskühleinrichtung (12) elektrisch verbindbar ist.
